# EUROPEAN PATENT SPECIFICATION

(11) **EP 0 427 557 B1**
(45) Date of publication and mention of the grant of the patent: **29.01.1997**
(21) Application number: 90312268.7
(22) Date of filing: 09.11.1990
(51) Int. Cl.: H03F 1/52

(54) **An amplifier circuit**
Eine Verstärkerschaltung
Un circuit amplificateur

(30) Priority: 10.11.1989 JP 293728/89
(43) Date of publication of application: 15.05.1991
(73) Proprietor: FUJITSU LIMITED, Kawasaki-shi, Kanagawa 211 (JP)
(72) Inventor: Kobayashi, Osamu, Yokohama-shi, Kanagawa 223 (JP)
(74) Representative: Billington, Lawrence Emlyn

(56) References cited:
- EP-A- 0 142 177
- EP-A- 0 161 154
- FR-A- 2 231 140
- GB-A- 2 036 490
- GB-A- 2 214 745
- PATENT ABSTRACTS OF JAPAN, vol. 10, no. 240 (E-429)[2296], 19th August 1986; & JP-A-61 70 809 (MATSUSHITA ELECTRIC IND. CO., LTD) 11- 04-1986
- IEEE 1987 SOLID-STATE CIRCUITS CONFERENCE, vol. 30, first edition, February 1987, pages 168-169,385; K.-Y. TOH et al.: "A matched impedance NMOS amplifier"

## Description

The present invention relates to an amplifier circuit for high-speed operation, which is protected from excess current.

Recently, there has been increasing demand for a high-speed large-scale integrated circuit which is capable of handling a large current for driving a peripheral circuit. Demand exists for an analogue LSI as well as a digital LSI. It is necessary to speed up the operation of an analogue circuit and to drive it with a large current. Thus, an amplifier such as an operation amplifier must be speeded up or subjected to a large current drive. It is necessary to drive the analogue circuit with a large current. Thus, the LSI itself and the peripheral circuit must be protected from an excess current upon an excess load such as a load short-circuit by a current-limiting function provided to the LSI itself or to the peripheral circuit.

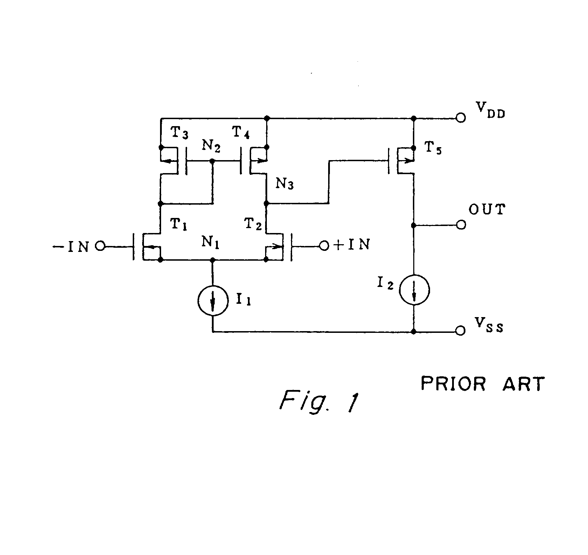

Figure 1 shows an example of a differential amplifier circuit (such as a comparator) composed of a CMOS. T₁ and T₂ are a pair of differential N-channel driving transistors and T₃ and T₄ form a current mirror circuit by using a P-channel load transistor. T₅ is a P-channel transistor in the output stage and I₁ and I₂ are constant current sources. +IN and -IN, respectively, are the non-inverting and inverting inputs, and OUT is the output.

In this differential amplifier circuit, T₁ turns on and T₂ turns off when -IN > +IN. Thus, the voltage level of node N₃ then increases, thereby turning T₅ off and providing the output OUT with L level. Conversely, T₁ turns off and T₂ turns on when -IN < +IN. Thus, the voltage level of node N₃ decreases, thereby turning T₅ on and providing output OUT with H level. When the transistor operates in saturation region, the above recited ON state means that a current larger than the standard operating point current is caused to flow and the OFF state means that a current smaller than the standard operating point current is caused to flow.

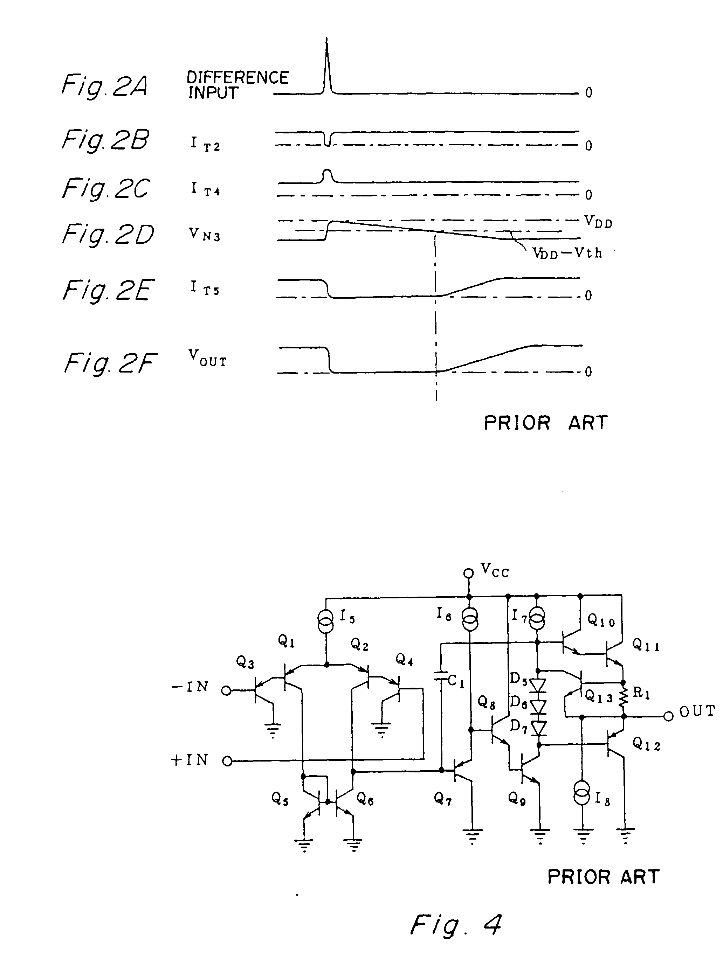

As shown in Figure 2A, when an excess difference input voltage V_{(-IN)} - V_{(+IN)} is applied to this circuit, T₁ turns on and T₂ turns off, thereby enabling transistor T₁ to cause a whole output current of a constant current source I₁ to flow and enabling transistor T₂ to cause a current I_{T2} to be 0. The current of transistor T₁ is equal to that of transistor T₃, and T₃ and T₄ form a current mirror circuit. Thus, the current of T₄ is proportional to the current of T₃ (the current of T₄ is the same as the that of T₃.) Accordingly, the current I_{T4} of transistor T₄ tends to increase as shown in Figure 2C, but the current I_{T4} can not flow as transistor T₂ is turned off. Transistor T₄ is strongly driven and the voltage drop between the drain and source becomes almost 0. Thus, the potential V_{N3} of node N₃ increases to the source voltage V_{DD}. Thus, transistor T₅ turns off and the output voltage V_{OUT} becomes equal to the voltage V_{SS} (which is 0 Volts in this embodiment).

If the excess difference input ends instantaneously as shown in Figure 2A, and thereafter the input difference becomes 0, transistors T₁ and T₂ turn on and cause I₁/2 to flow. This I₁/2 is equal to the current caused to flow by transistors T₃ and T₄. Node N₃ is driven at the voltage V_{DD} by the excess difference input. When the difference input is 0, the voltage decreases more. However, when I_{T4} is equal to I_{T2}, it takes time for node N₃ to discharge the charge therein. Thus, the potential N₃ of node N₃ gradually decreases, as shown in Figure 2D. When the voltage V_{N3} is less than V_{DD} - Vₜₕ (where Vₜₕ is the threshold voltage of transistor T₅), transistor T₅ turns on, thereby causing the current I_{T5} to flow and voltage V_{OUT} to increase.

As stated above, if an excess input is applied to the amplifier, the internal voltage of the amplifier deviates from its normal operation and takes time to be restored. Thus, it can not perform a normal operation within a restoring period, and high-speed operation is not achieved.

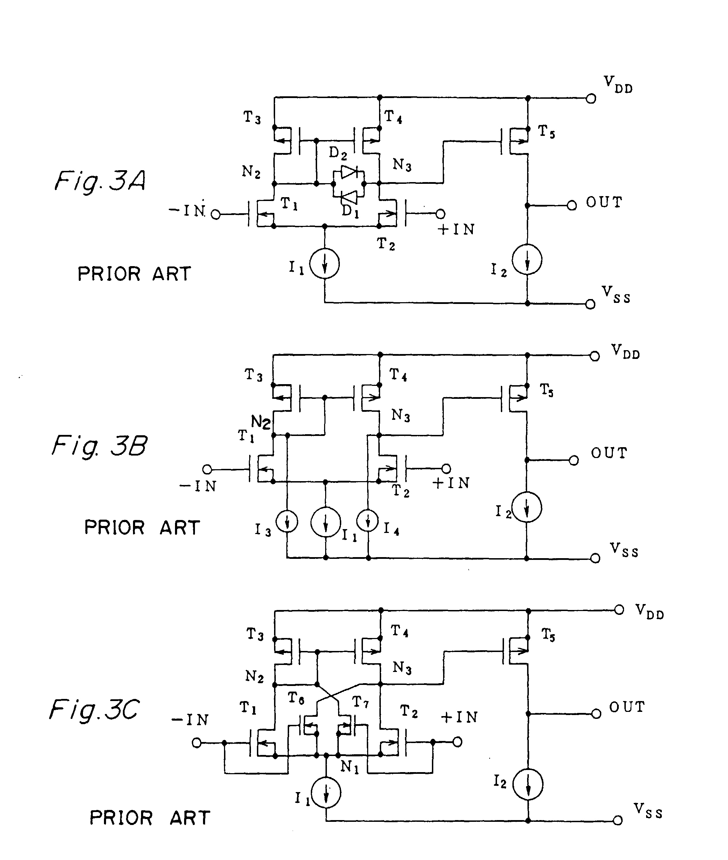

To solve this problem, the prior art is provided with the countermeasure shown in Figure 3. In Figure 3A, diodes D₁ and D₂ of reverse parallel connection are connected between nodes N₂ and N₃, thus limiting the amplitude of the potential of node N₃ and tending to produce high-speed operation. The limitation of the amplitude when the potential of node N₃ tends to increase to the voltage V_{DD}, can only be performed by diode D₁. In Figure 3B, the current sources I₃ and I₄ are inserted between the nodes N₂ to N₃ and the low potential side source V_{SS} to prevent transistors T₃ and T₄ from being in a non-current state when transistors T₁ or T₂ are cut off by the excess input and to prevent the potential increase in nodes N₂ and N₃ from being excessive. In Figure 3C, transistors T₆ and T₇ are connected between the nodes N₂ and N₃ and node N₁, and transistors T₆ and T₇ are controlled by -IN and +IN so that T₇ is on when T₁ is off and T₆ is on when T₂ is off, thereby preventing transistors T₃ and T₄ from being in a non-current state and preventing an excess potential increase in nodes N₂ and N₃. The same parts are represented by the same symbols throughout the all drawings.

However, in the circuit shown in Figure 3A, the CMOS IC should be formed of a MOS diode. When the CMOS IC is formed of junction type diodes D₁ and D₂, a parasitic thyristor is formed, causing latch up phenomena. The circuits shown in Figures 3B and 3C do not perform an amplitude limitation directly. Thus, they can not achieve a sufficient effect and can not perform a sufficient high speed operation.

Next, the excess current is discussed. If a load short-circuit occurs, an excess output current flows and the transistor in the output stage is destroyed. In a small-current FET, a load short-circuit does not cause a great problem as the load current is suppressed because of the saturation characteristics of a small current FET, but a circuit having a large current-driving capability has the problem of a load short-circuit.

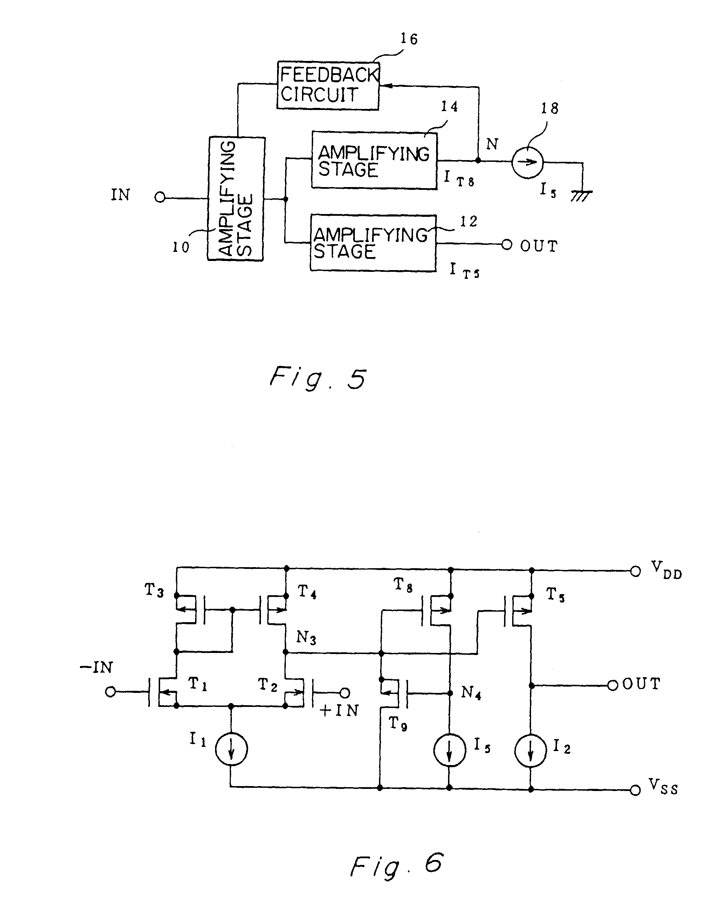

Figure 4 shows an example of a circuit in which an excess current is prevented by using an emitter-follower. Q₁ to Q₆ are bipolar transistors forming a differential pair at the input stage. The non-inverting and inverting inputs +IN and -IN are applied to the bases of transistors Q₄ and Q₃. Transistors Q₅ and Q₆ form a current mirror. I₅ - I₈ form a constant current source, bipolar transistors Q₁₀ - Q₁₂ form an output stage, Q₇ - Q₉ form the driving stage, C₁ is a phase compensation capacitor, R₁ is a current sensing resistor, D₅ - D₇ are level shifting diodes, and Q₁₃ is a bipolar transistor. Resistor R₁ and transistor Q₁₃ prevent an excess current.

When the load current increases and hence the voltage drop across the resistor R₁ increases, transistor Q₁₃ is be turned on, and the base current of the Darlington pair Q₁₀ and Q₁₁ is bypassed. As a result, transistors Q₁₀ and Q₁₁ are driven in the direction such that they are turned off and the load current is prevented from becoming excessive. More specifically, when an external load is supplied at a current I from the output terminal OUT, the current I is mainly supplied through Q₁₁ and R₁. When the current I increases and hence the voltage drop IR₁ across the resistor R₁ exceeds V_{BEO} (the specific base-to-emitter voltage of approximately 0.6-0.7 volts) of the transistor Q₁₃, the transistor Q₁₃ will begin to conduct. Then, the base voltage of Q₁₀ and hence the base voltage of Q₁₁ will be decreased and the emitter voltage of Q₁₁ and the output voltage at OUT will be subsequently decreased, thereby reducing the supply current I to the external load. Finally, the current I will be limited to a level which satisfies IR₁ ≒ 0.6 - 0.7 volts (in other words, to the extent that Q₁₃ begins to conduct a current).

The circuit of Figure 4, which performs a current limiting function, is a bipolar transistor circuit, not a CMOS circuit. With a CMOS amplifier, a source follower does not have as low an impedance as an emitter follower of a bipolar amplifier. Thus, a CMOS circuit corresponding the the circuit of Figure 4 is not used. In a CMOS configuration, the currents of transistor T₅ and current source I₂ are made high in Figure 1, thereby providing high-current driving capability.

With the system of Figure 3A adapted to speed up the operation of the CMOS amplifier, there are problems with the protection diodes D₁ and D₂. With the systems of Figures 3B and 3C, on the other hand, a sufficient effect cannot be expected. There is a bipolar transistor amplifier sufficient for overcurrent limiting, as shown in Figure 4, but there is no satisfactory CMOS amplifier.

IEEE 1987 Solid State Circuits Conference Vol.30, Feb. 1987 pages 168, 169, 385, K.-Y. Toh et al, discloses a matched impedance NMOS amplifier having a block diagram similar to Figure 5 of the attached drawings. However the aim of this circuit is to provide impedance matching and it does not address the problems dealt with by the present invention, namely overcurrent limitation and avoidance of cut-off states, by a circuit able to cope with high speeds.

It is therefore an object of the present invention to provide an amplifier circuit which is adapted for high-speed circuit operation and overcurrent prevention.

According to a first aspect of the present invention there is provided an amplifier circuit comprising:
a first, second and third amplifying stage and a feedback circuit, characterised by the first amplifying stage comprising a first transistor having a gate or base for receiving a first input voltage and a second transistor having a gate or base for receiving a second input voltage the first transistor and the second transistor forming a differential pair of driving transistors;
the second amplifying stage, comprising a third transistor connected in series with a first constant current source, located between a first power source and a second power source, the third transistor having a gate or a base connected to an output node of the first amplifying stage and outputting a voltage level in accordance with a voltage level at the output node;
the third amplifying stage, comprising a fourth transistor connected in series with a second constant current source, located between the first power source and the second power source, the fourth transistor having a gate or a base connected to the output node and outputting an output current being a fixed proportion of an output current of the third transistor; and
the feedback circuit comprising a fifth transistor connected between the output node and the second power source, the fifth transistor having a gate or a base connected to a first node which connects the fourth transistor and the second constant current source and being turned ON by a potential drop at the first node caused by a potential rise at the output node and operable to control the potential rise at the output node.

According to a second aspect of the invention there is provided an amplifier circuit comprising:
a first, second and third amplifying stage and a feedback circuit, characterised by the first amplifying stage comprising, a first transistor having a gate or a base for receiving first input voltage, a second transistor having a gate or a base for receiving a second input voltage, a seventh transistor, and an eighth transistor, in which the first transistor and the second transistor form a first differential pair of driving transistors, the seventh transistor and the eighth transistor form a current mirror circuit, the first transistor and the seventh transistor are connected in series with a fourth constant current source and are located between a first power source and a second power source, and the second transistor and the eighth transistor are connected in series with the fourth constant current source and are located between the first power source and the second power source;
the second amplifying stage, comprising a third transistor connected in series with a first constant current source, and located between the first power source and the second power source, the third transistor having a gate or a base connected to an output node of the first amplifying stage which connects the second transistor and the eighth transistor and outputting a voltage level in accordance with a voltage level at the output node;
the third amplifying stage, comprising a fourth transistor connected in series with a second constant current source, and located between the first power source and the second power source, the fourth transistor having a gate or a base connected to the output node and outputting a current being a fixed proportion of an output current of the third transistor; and
the feedback circuit comprising a ninth transistor connected between the fourth constant current source and the connecting point of a gate or a base of the seventh transistor and a gate or a base of the eighth transistor, the ninth transistor having a gate or a base connected to a first node which connects the fourth transistor and the second constant current source and being turned ON according to a rise in potential at the first node to raise the potential at the output node when an output current of the third transistor becomes equal to or larger than a predetermined value.

An embodiment of the present invention considered at the block diagram level comprises an amplifier circuit having a first amplifying stage for receiving an input signal and amplifying it to provide an output signal, a second amplifying stage for receiving the output signal of the first amplifying stage and amplifying it to provide an output signal, a third amplifying stage for receiving the output signal of the first amplifying stage and having its output terminal connected to a constant current source, and a feedback circuit connected between the junction of the third amplifying stage and the constant current source and the first amplifying stage, the ratio of an output current of the second amplifying stage to that of the third amplifying stage being fixed and the feedback circuit controlling the output of the first amplifying stage only when the potential at the junction of the third amplifying stage and the constant current source is either above or below a specified potential.

For a better understanding of the invention and to show how the same may be carried into effect, reference will now be made, purely by way of example, to the accompanying drawings in which:-
Figure 1 is a circuit diagram of a conventional CMOS amplifier circuit;
Figures 2A through 2F are diagrams which illustrate the operation of the amplifier circuit shown in Figure 1;
Figures 3A through 3C are circuit diagrams of conventional CMOS amplifier circuits adapted for high-speed circuit operation;
Figure 4 is a circuit diagram of a conventional bipolar transistor amplifier circuit adapted for overcurrent protection;
Figure 5 is a basic block diagram illustrating the principle of the present invention;
Figure 6 is a circuit diagram of an amplifier circuit according to the first embodiment of the present invention;
Figures 7A through 7H are diagrams which illustrate the operation of the amplifier circuit shown in Figure 6;
Figure 8 is a circuit diagram of an amplifier circuit according to the second embodiment of the present invention;
Figures 9A through 9H are diagrams which illustrate the operation of the amplifier circuit shown in Figure 8; and
Figure 10 is a circuit diagram of an amplifier circuit according to the third embodiment of the present invention.

As illustrated in Figure 5, the amplifier circuit of the present invention is composed of three amplifying stages 10, 12 and 14; a constant current source 18; and a feedback circuit 16.

The first amplifying stage 10 receives an input signal IN and provides an output signal to the second and third amplifying stages 12 and 14. The output of the second amplifying stage 12 is used as the output OUT of the present amplifier circuit. The output of the third amplifying stage 14 is connected to inputs of the constant current source 18 and the feedback circuit 16. The output of the feedback circuit 16 is connected to the first amplifying stage 10.

The second and third amplifying stages 12 and 14 are set such that their output currents are in a constant ratio. The feedback circuit 16 is adapted to control the first amplifying stage 10 only when the input signal of the feedback circuit 16 is above or below a fixed level. The first and third amplifying stages 10 and 14, the constant current source 18 and the feedback circuit 16 form a negative feedback control system.

In th amplifier circuit, the input signal IN is amplified by the amplifying stages 10 and 12 to provide the output OUT, and the output of the amplifying stage 10 is controlled by the negative feedback control system including the amplifying stage 14.

The output signals of the amplifying stages 12 and 14 are obtained in terms of current and the output currents are in a fixed ratio. The voltage at node N, which is the junction of the amplifying stage 14 and the constant current source 18, is determined by the difference between the output current of the amplifying stage 14 and the current of the constant current source 18. The feedback circuit 16 feeds the voltage at the node N back to the amplifying stage 10, thereby controlling the output of the amplifier 10 only when the voltage at node N is higher or lower than a fixed voltage.

Assuming that the output currents of the amplifying stages 12 and 14 are I_{T5} and I_{T8}, respectively, I_{T5} and I_{T8} are related by : I_{T5} = A I_{T8} where A is a constant. Assuming that the current of the constant current source 18 is I₅ and the voltage at the node is V, V becomes high when I_{T8} - I₅ > 0, and low when I_{T8} - I₅ < 0. When V is high, the feedback circuit 16 limits the maximum value of current drawn from the output OUT, thereby preventing overcurrent or preventing the current-sinking transistor of the amplifying stage 12 from becoming cut off, thereby achieving high speed circuit operation. When V is low, on the other hand, the feedback circuit limits the maximum value of sink current, thereby preventing overcurrent or preventing the output-stage transistor of the amplifying stage 12 from being cut off, thereby achieving high-speed circuit operation.

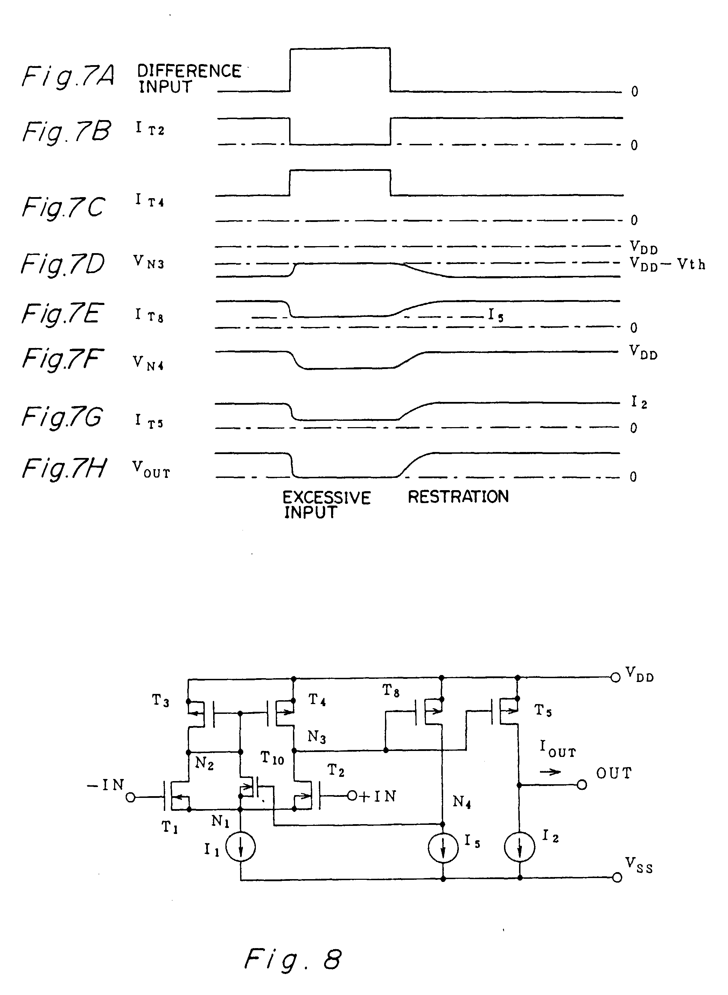

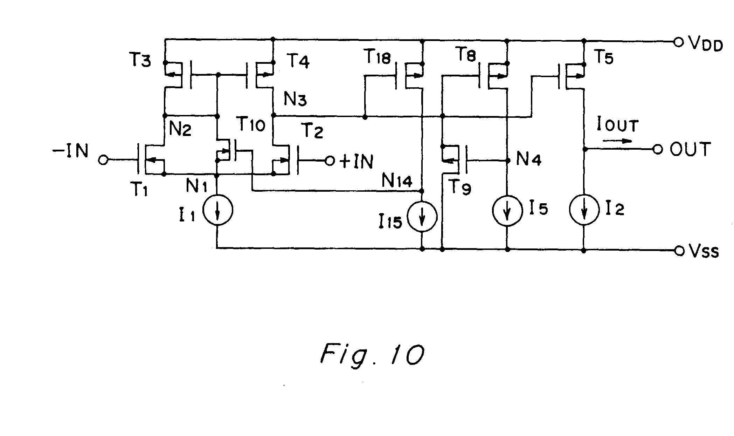

Figures 6, 8 and 10 illustrate the first, second and third embodiments of the present invention, respectively. Comparisons of these Figures with Figure 1 show that each has a P-channel transistor T₈ and a constant current source I₅ added to it. A P-channel transistor T₉ is further added to the circuit in Figure 6; an N-channel transistor T₁₀ to the circuit in Figure 8; and P-channel transistors T₉ and T₁₈, an N-channel transistor T₁₀ and a constant current source I₁₅ to the circuit in Figure 10. T₁ through T₄ and I₁ form the amplifying stage 10 of Figure 5, T₅ and I₂ form the amplifying stage 12, T₈ and T₁₈ form the amplifying stage 14, and I₅ and I₁₅ form the constant current source 18. T₉ in Figure 6, T₁₀ in Figure 8 and T₉ and T₁₀ in Figure 10 each correspond to the feedback circuit 16 of Figure 5.

The first embodiment, illustrated in Figure 6, is adapted to prevent the output-stage transistor T₅ from becoming cut off, thereby achieving high-speed circuit operation. The operation of the first embodiment is described below with reference to Figures 7A through 7H.

In the circuit of Figure 6, the currents of I₂ and T₅ are normally equal when OUT is midway between V_{DD} and V_{SS}. Since they have the same characteristics, transistors T₅ and T₈ will conduct the same current I₂. Since I₅ and I₂ are set such that I₅ < I₂, the potential at node N₄ is raised to a level in the neighborhood of V_{DD}. Therefore, T₉ is normally turned off.

As in the circuit of Figure 1, when excessively different input signals such as those illustrated in Figure 7A are applied in a direction to cause V_{(+IN)} < V_{(-IN)}, transistor T₁ will be turned on, while transistor T₂ will be turned off. Thus, the voltage drop across T₄ decreases so that the potential at N₃ approaches V_{DD} as transistors T₃ and T₄ of the current mirror circuit are driven to cause a current I₁ to flow. This decreases the currents of T₅ and T₈ so that the output voltage at OUT decreases immediately, as shown in Figure 7H, and after some delay the current I_{T8} of T₈ becomes smaller than I₅, as shown in Figure 7E. Consequently, the potential V_{N4} at N₄ will also be lowered, as shown in Figure 7F. When the potential V_{N4} at N₄ becomes lower than the potential V_{N3} at N₃ by at least the the threshold voltage Vₜₕ of the transistor T₉, T₉ will begin to conduct so that current flows from N₃ to V_{SS}. At this point the elevation of the potential at N₃ is stopped. In this stage, transistors T₈ and T₅ each conduct the current I₅. That is, they are not in the cut-off state. Thus, when the excessive input is removed, the amplifier circuit can immediately prepare to accommodate the next input signal.

In the conventional circuit illustrated in Figure 1, when an excessive input signal is applied, T₅ is placed in the cut-off state so that, even if the excessive input signal is removed, no response can be made until T₅ gets out of the cut-off state. However, the circuit of the present embodiment can attain remarkable high-speed circuit operation because T₅ and T₈ are not cut off even when an excessive input signal is applied. Thus, when the excessive input signal is removed, the circuit can immediately prepare to accommodate the next input signal.

Note, that the gain factors β₅ and β₈ of transistors T₅ and T₈ are set to satisfy β₅/β₈ = A/1, and I₅ = I₂/A - α< I₂/A. Here, A may be either A ≧ 1 or A ≦ 1, and α may be any value that satisfies 0 < α < I₂/A.

Next, the second embodiment, shown in Figure 8, is adapted to limit the current of the output-stage transistor T₅ to protect the circuit against overcurrent.

As illustrated in Figure 8, the amplifier circuit of the present embodiment may be considered to have a configuration in which feedback is provided to an amplifier having the same arrangement as the circuit of Figure 1 through transistors T₈ and T₁₀ and the constant current source I₅. In this case, the amplifier operates so as to hold its output voltage V_{OUT} constant even if a variation occurs in a load (R_{L}, I_{OUT}, etc.). That is, when R_{L} becomes small so that I_{OUT} increases and V_{OUT} decreases, the -IN voltage of Figure 8 (= V_{OUT}) also decreases. Thus, the current of T₁ (= the current of T₃ = the current of T₄) decreases and the current of T₂ increases. As a result, the potential at N₃ falls. Then, the current of T₅ increases, thereby preventing V_{OUT} from decreasing.

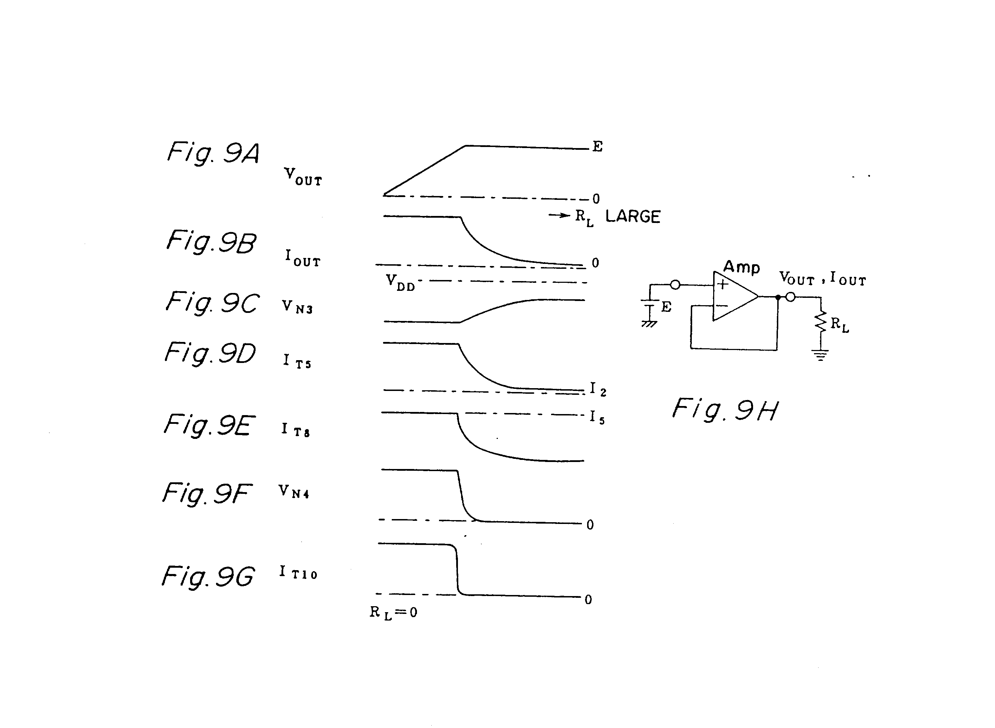

Assuming that T₈ and T₅ have the same characteristics and I₅ > I₂, since normally I_{T8} = I_{T5} = I₂ < I₅, the voltage of N₄ is in the neighborhood of V_{SS} and thus T₁₀ is turned off. When I_{OUT} increases, it is limited to a fixed value as shown in Figures 9A through 9G. That is, when I_{OUT} increases and thus I_{T5} (= I_{T8}) increases, resulting in I_{T8} ≧ I_{T5}, the potential at N₄ rises. When the potential at N₄ becomes higher than that at N₁ by at least the threshold voltage Vₜₕ of T₁₀, T₁₀ conducts, causing current to flow in T₃ and T₄. Thus, the potential at N₃ is raised, thereby preventing the currents of T₅ and T₈ from increasing further. As a result, I_{OUT} is limited.

Thus, according to the present embodiment, satisfactory overcurrent protection can also be realized by a CMOS amplifier circuit.

The third embodiment, illustrated in Figure 10, is adapted to keep the output-stage transistor T₅ from becoming cut off and to limit the current to simultaneously realize high-speed circuit operation and overcurrent protection.

As shown in Figure 10, the circuit of the present embodiment combines the circuits of Figure 6 and Figure 8. That is, T₈, T₉, N₄ and I₅ in Figure 10 are adapted to high-speed circuit operation and correspond to T₈, T₉, N₄ and I₅, respectively, in Figure 6. Also, T₁₈, T₁₀, N₁₄ and I₁₅ in Figure 10, are adapted to overcurrent protection and correspond to T₈, T₁₀, N₄ and I₅, respectively, in Figure 8.

The operation of the present embodiment may also be considered to be a combination of the operations of the embodiments shown in Figure 6 and Figure 8. That is, when -IN > +IN, T₅ is cut off. However, T₅ is prevented from becoming cut off by the same operation as in the circuit of Figure 6, thus enabling fast recovery. In addition, even if the output current I_{OUT} increases, it will be limited by the same operation as the circuit of Figure 8.

The above embodiments are directed to only CMOS amplifier circuits. However, the amplifier circuits of the present invention may be composed of bipolar transistors only. In this case, it is necessary only that the N-channel MOS transistors be replaced with NPN bipolar transistors and the P-channel MOS transistors be replaced with PNP bipolar transistors. In operation as well, the amplifier circuits using bipolar transistors are the same as the corresponding CMOS amplifier circuits illustrated in the drawings and described above.

As described above, according to the present invention, a maximum value and/or a maximum value of current in the output stage transistor of an amplifier circuit can be limited, thereby achieving fast recovery after application of an excessive input signal. This is because the output transistor is prevented from becoming cut off and/or because the circuit is protected by output current limitation.

## Claims

1. An amplifier circuit comprising:
a first (10), second (12) and third (14) amplifying stage and a feedback circuit (15), characterised by the first amplifying stage (10) comprising a first transistor (T₁) having a gate or base for receiving a first input voltage (-IN) and a second transistor (T₂) having a gate or base for receiving a second input voltage (+IN) the first transistor (T₁) and the second transistor (T₂) forming a differential pair of driving transistors;
the second amplifying stage, (12) comprising a third transistor (T₅) connected in series with a first constant current source (I₂), located between a first power source (V_{DD}) and a second power source (V_{SS}), the third transistor (T5) having a gate or a base connected to an output node (N₃) of the first amplifying stage (10) and outputting a voltage level in accordance with a voltage level at the output node (N₃) ;
the third amplifying stage (14), comprising a fourth transistor (T₈) connected in series with a second constant current source (I₅), located between the first power source (V_{DD}) and the second power source (V_{SS}), the fourth transistor (T₈) having a gate or a base connected to the output node (N₃) and outputting an output current being a fixed proportion of an output current of the third transistor (T₅) ;
further characterised by
the feedback circuit (16) comprising a fifth transistor (T₉) connected between the output node (N₃) and the second power source (V_{SS}), the fifth transistor (T₉) having a gate or a base connected to a first node (N₄) which connects the fourth transistor (T₈) and the second constant current source (I₅) and being turned ON by a potential drop at the first node (N₄) caused by a potential rise at the output node (N₃) and operable to control the potential rise at the output node (N₃).

2. An amplifer circuit according to claim 1, further comprising a sixth transistor (T₁₈) connected in series with a third constant current source (I₁₅) and being located between the first power source (V_{DD}) and the second power source (V_{SS}), wherein
a gate or a base of the sixth transistor (T₁₈) is connected to the output node (N₃),
the ratio of the output current of the sixth transistor (T₁₈) to that of the third transistor (T₅) is fixed,
the first amplifying stage (10) further comprises a seventh transistor (T₃), eighth transistor (T₄), and fourth constant current source (I₁),
the seventh transistor (T₃) and the eighth transistor (T₄) form a current mirror circuit,
the first transistor (T₁) and the seventh transistor (T₃) are connected in series with the fourth constant current source (I₁) and are located between the first power source (V_{DD}) and the second power source (V_{SS}),
the second transistor (T₂) and the eighth transistor (T₄) are connected in series with the fourth constant current source (I₁) and are located between the first power source (V_{DD}) and the second power source (V_{SS}),
the feedback circuit (16) further comprises a ninth transistor (T₁₀) connected between the fourth constant current source (I₁) and a connection point of the gate or the base of the seventh transistor (T₃) and the gate or the base of the eighth transistor (T₄),
a gate or a base of the ninth transistor (T₁₀) is connected to a second node (N₁₄) which connects the sixth transistor (T₁₈) and the fourth constant current source (I₁), and
when the output current of the third transistor (T₅) becomes equal to or larger than a predetermined value, the ninth transistor (T₁₀) turns ON in accordance with a rise in potential at the second node (N₁₄) to raise the potential at the output node (N₃).

3. An amplifier circuit comprising:
a first (10), second (12) and third (14) amplifying stage and a feedback circuit (15),
characterised by the first amplifying stage (10) comprising, a first transistor (T₁) having a gate or a base for receiving first input voltage (-IN), a second transistor (T₂) having a gate or a base for receiving a second input voltage (+IN), in which the first transistor (T₁) and the second transistor (T₂) form a first differential pair of driving transistors,
the second amplifying stage (12), comprising a third transistor (T₅) connected in series with a first constant current source (I₂), and located between the first power source (V_{DD}) and the second power source (V_{SS}), the third transistor (T₅) having a gate or a base connected to an output node (N₃) of the first amplifying stage which connects the second transistor (T₂) and an eighth transistor (T₄) and outputting a voltage level in accordance with a voltage level at the output node (N₃);
the third amplifying stage (14), comprising a fourth transistor (T₈) connected in series with a second constant current source (I₅), and located between the first power source (V_{DD}) and the second power source (V_{SS}), the fourth transistor (T₈) having a gate or a base connected to the output node (N₃) and outputting a current being a fixed proportion of an output current of the third transistor (T₅);
further characterised by
the first amplifying stage (10) further comprising a seventh transistor (T₃), and an eighth transistor (T₄) ,
the seventh transistor (T₃) and the eighth transistor (T₄) form a current mirror circuit, the first transistor (T₁) and the seventh transistor (T₃) are connected in series with a fourth constant current source (I₁) and are located between a first power source (V_{DD}) and a second power source (V_{SS}), and the second transistor (T₂) and the eighth transistor (T₄) are connected in series with the fourth constant current source (I₁) and are located between the first power source (V_{DD}) and the second power source (V_{SS}); and
the feedback circuit (16) comprising a ninth transistor (T₁₀) connected between the fourth constant current source (I₁) and the connecting point of a gate or a base of the seventh transistor (T₃) and a gate or a base of the eighth transistor (T₄), the ninth transistor (T₁₀) having a gate or a base connected to a first node (N₄) which connects the fourth transistor (T₈) and the second constant current source (I₅) and being turned ON according to a rise in potential at the first node (N₄) to raise the potential at the output node (N3) when an output current of the third transistor (T₅) becomes equal to or larger than a predetermined value.

4. The amplifier circuit according to claim 1, 2 or 3 in which said first amplifying stage, said third amplifying stage and said feedback circuit form a negative feedback loop.

5. The amplifier circuit according to claim 1 or claim 2, in which said negative feedback loop is arranged to limit the minimum current flowing through the third transistor (T₅) contained in said second amplifying stage (12), thereby preventing said third transistor from becoming cut off.

6. The amplifier circuit according to claim 1, claim 2 or claim 5, in which said negative feedback loop is arranged to limit the maximum current flowing through the third transistor (T₅) contained in said second amplifying stage (12), thereby preventing an excessive output current.

7. An amplifier circuit according to any one of claims 1 to 6, in which transistors contained in said first, second and third amplifying stages and said negative feedback circuit are MOS transistors.

8. An amplifier circuit according to any one of claims 1 to 6, in which transistors contained in said first, second and third amplifying stages and said negative feedback circuit are bipolar transistors.

## Patentansprüche

1. Verstärkerschaltung, mit:
einer ersten (10), einer zweiten (12) und einer dritten (14) Verstärkerstufe und einer Rückkopplungsschaltung (15),dadurch **gekennzeichn**et, daß die erste Verstärkerstufe (10) einen ersten Transistor (T₁) mit einem Gate oder einer Basis zum Empfangen einer ersten Eingangsspannung (-IN) und einen zweiten Transistor (T₂) mit einem Gate oder einer Basis zum Empfangen einer zweiten Eingangsspannung (+IN) aufweist, wobei der erste Transistor (T₁) und der zweite Transistor (T₂) ein Differentialpaar von Treibertransistoren bilden;
die zweite Verstärkerstufe (12) einen dritten Transistor (T₅) aufweist, der in Reihe mit einer ersten Konstantstromquelle (I₂) geschaltet ist, die zwischen einer ersten Stromversorgungsquelle (V_{DD}) und einer zweiten Stromversorgungsquelle (V_{SS}) gelegen ist, wobei der dritte Transistor (T₅) ein Gate oder eine Basis aufweist, das bzw. die mit einem Ausgangsknotenpunkt (N₃) der ersten Verstärkerstufe (10) verbunden ist, und der einen Spannungspegel entsprechend einem Spannungspegel an dem Ausgangsknotenpunkt (N₃) ausgibt;
die dritte Verstärkerstufe (14) einen vierten Transistor (T₈) aufweist, der in Reihe mit einer zweiten Konstantstromquelle (I₅) geschaltet ist, die zwischen der ersten Stromversorgungsquelle (V_{DD}) und der zweiten Stromversorgungsquelle (V_{SS}) gelegen ist, wobei der vierte Transistor (T₈) ein Gate oder eine Basis aufweist, das bzw. die mit dem Ausgangsknotenpunkt (N₃) verbunden ist und einen Ausgangsstrom ausgibt, der einen festen Anteil eines Ausgangsstromes des dritten Transistors (T₅) aufweist, und dadurch gekennzeichnet, daß die Rückkopplungsschaltung (16) einen fünften Transistor (T₉) aufweist, der zwischen den Ausgangsknotenpunkt (N₃) und die zweite Stromversorgungsquelle (V_{SS}) geschaltet ist, wobei der fünfte Transistor (T₉) ein Gate oder eine Basis aufweist, das bzw. die mit einem ersten Kontenpunkt (N₄) verbunden ist, welcher den vierten Transistor (T₈) und die zweite Konstantstromquelle (I₅) verbindet, und der durch einen Potentialabfall an dem ersten Knotenpunkt (N₄) EIN geschaltet wird, der durch einen Potentialanstieg an dem Ausgangsknotenpunkt (N₃) verursacht wird und so betreibbar ist, um den Potentialanstieg an dem Ausgangsknotenpunkt (N₃) zu steuern.

2. Verstärkerschaltung nach Anspruch 1, die ferner aufweist einen sechsten Transistor (T₁₈), der in Reihe mit einer dritten Konstantstromquelle (I₁₅) geschaltet ist und zwischen der ersten Stromversorgungsquelle (V_{DD}) und der zweiten Stromversorgungsquelle (V_{SS}) gelegen ist, wobei
ein Gate oder eine Basis des sechsten Transistors (T₁₈) mit dem Ausgangsknotenpunkt (N₃) verbunden ist,
das Verhältnis des Ausgangsstromes des sechsten Transistors (T₁₈) zu demjenigen des dritten Transistors (T₅) festgelegt ist,
die erste Verstärkerstufe (10) ferner einen siebten Transistor (T₃), einen achten Transistor (T₄) und eine vierte Konstantstromquelle (I₁) aufweist,
wobei der siebte Transistor (T₃) und der achte Transistor (T₄) eine Stromspiegelschaltung bilden,
der erste Transistor (T₁) und der siebte Transistor (T₃) in Reihe mit der vierten Konstantstromquelle (I₁) geschaltet sind und zwischen der ersten Stromversorgungsquelle (V_{DD}) und der zweiten Stromversorgungsquelle (V_{SS}) gelegen sind,
der zweite Transistor (T₂) und der achte Transistor (T₄) mit der vierten Konstantstromquelle (I₁) in Reihe geschaltet sind und zwischen der ersten Stromversorgungsquelle (V_{DD}) und der zweiten Stromversorgungsquelle (V_{SS}) gelegen sind,
die Rückkopplungsschaltung (16) ferner einen neunten Transistor (T₁₀) aufweist, der zwischen die vierte Konstantstromquelle (I₁) und einem Verbindungspunkt des Gate oder der Basis des siebten Transistors (T₃) und dem Gate oder der Basis des achten Transistors (T₄) geschaltet ist,
ein Gate oder eine Basis des neunten Transistors (T₁₀) mit einem zweiten Knotenpunkt (N₁₄) verbunden ist, der den sechsten Transistor (T₁₈) und die vierte Konstantstromquelle (I₁) verbindet, und
dann, wenn der Ausgangsstrom des dritten Transistors (T₅) gleich wird oder größer wird als ein vorbestimmter Wert, der neunte Transistor (T₁₀) entsprechend einem Anstieg des Potentials an dem zweiten Knotenpunkt (N₁₄) EIN geschaltet wird, um das Potential an dem Ausgangsknotenpunkt (N₃) anzuheben.

3. Verstärkerschaltung, mit:
einer ersten (10), einer zweiten (12) und einer dritten (14) Verstärkerstufe und einer Rückkopplungsschaltung (15), dadurch **gekennzeichnet**, daß die erste Verstärkerstufe (10) einen ersten Transistor (T₁) mit einem Gate oder einer Basis zum Empfangen einer ersten Eingangsspannung (-IN), einen zweiten Transistor (T₂) mit einem Gate oder einer Basis zum Empfangen einer zweiten Eingangsspannung (+IN) aufweist, wobei der erste Transistor (T₁) und der zweite Transistor (T₂) ein erstes Differentialpaar von Treibertransistoren bilden,
die zweite Verstärkerstufe (12) einen dritten Transistor (T₅) aufweist, der in Reihe mit einer ersten Konstantstromquelle (I₂) geschaltet ist und zwischen der ersten Stromversorgungsquelle (V_{DD}) und der zweiten Stromversorgungsquelle (V_{SS}) gelegen ist, wobei der dritte Transistor (T₅) ein Gate oder eine Basis aufweist, das bzw. die mit einem Ausgangsknotenpunkt (N₃) der ersten Verstärkerstufe verbunden ist, der den zweiten Transistor (T₂) und einen achten Transistor (T₄) miteinander verbindet und der einen Spannungspegel in Abhängigkeit von einem Spannungspegel an dem Ausgangsknotenpunkt (N₃) ausgibt;
die dritte Verstärkerstufe (14) einen vierten Transistor (T₈) aufweist, der in Reihe mit einer zweiten Konstantstromquelle (I₅) geschaltet ist und der zwischen der ersten Stromversorgungsquelle (V_{DD}) und der zweiten Stromversorgungsquelle (V_{SS}) gelegen ist, wobei der vierte Transistor (T₈) ein Gate oder eine Basis aufweist,das bzw die mit dem Ausgangsknotenpunkt (N₃) verbunden ist und einen Strom ausgibt, der einen festen Anteil eines Ausgangsstromes des dritten Transistors (T₅) bildet;
ferner dadurch gekennzeichnet, daß
die erste Verstärkerstufe (10) einen siebten Transistor (T₃) und einen achten Transistor (T₄) aufweist, wobei der siebte Transistor (T₃) und der achte Transistor (T₄) eine Stromspiegelschaltung bilden, der erste Transistor (T₁) und der siebte Transistor (T₃) in Reihe mit einer vierten Konstantstromquelle (I₁) geschaltet sind und zwischen einer ersten Stromversorgungsquelle (V_{DD}) und einer zweiten Stromversorgungsquelle (V_{SS}) gelegen sind, und wobei der zweite Transistor (T₂) und der achte Transistor (T₄) mit der vierten Konstantstromquelle (I₁) in Reihe geschaltet sind und zwischen der ersten Stromversorgungsquelle (V_{DD}) und der zweiten Stromversorgungsquelle (V_{SS}) gelegen sind; und
die Rückkopplungsschaltung (16) einen neunten Transistor (T₁₀) aufweist, der zwischen die vierte Konstantstromquelle (I₁) und den Verbindungspunkt eines Gate oder einer Basis des siebten Transistors (T₃) und einem Gate oder einer Basis des achten Transistors (T₄) geschaltet ist, wobei der neunte Transistor (T₁₀) ein Gate oder eine Basis aufweist, die mit einem ersten Knotenpunkt (N₄) verbunden ist, welcher den vierten Transistor (T₈) und die zweite Konstantstromquelle (I₅) verbindet, und der gemäß einem Anstieg im Potential an dem ersten Knotenpunkt (N₄) EIN geschaltet wird, um das Potential an dem Ausgangsknotenpunkt (N₃) anzuheben, wenn ein Ausgangsstrom des dritten Transistors (T₅) gleich wird oder größer wird als ein vorbestimmter Wert.

4. Verstärkerschaltung nach Anspruch 1, 2 oder 3, bei der die erste Verstärkerstufe, die dritte Verstärkerstufe und die Rückkopplungsschaltung eine Gegenkopplungsschleife bilden.

5. Verstärkerschaltung nach Anspruch 1 oder Anspruch 2, bei der die Gegenkopplungsschleife dafür ausgebildet ist, um den minimalen Strom zu begrenzen, der durch den dritten Transistor (T₅) fließt, welcher in der zweiten Verstärkerstufe (12) enthalten ist, um den dritten Transistor daran zu hindern, abgeschaltet zu werden.

6. Verstärkerschaltung nach Anspruch 1, Anspruch 2 oder Anspruch 5, bei der die Gegenkopplungsschleife dafür ausgebildet ist, um den maximalen Strom zu begrenzen, der durch den dritten Transistor (T₅) fließt, welcher in der zweiten Verstärkerstufe (12) enthalten ist, um dadurch einen übermäßigen Ausgangsstrom zu verhindern.

7. Verstärkerschaltung nach irgendeinem der Ansprüche 1 bis 6, bei der die Transistoren, die in der ersten, der zweiten und der dritten Verstärkerstufe und der Gegenkopplungsschaltung enthalten sind, MOS Transistoren sind.

8. Verstärkerschaltung nach irgendeinem der Ansprüche 1 bis 6, bei der die Transistoren, die in der ersten, der zweiten und der dritten Verstärkerstufe und der Gegenkopplungsschaltung enthalten sind, Bipolar-Transistoren sind.

## Revendications

1. Circuit amplificateur comprenant des premier (10), deuxième (12) et troisième étages d'amplification (14) et un circuit de contre-réaction (15) ;
caractérisé :
en ce que le premier étage d'amplification (10) comprend un premier transistor (T₁) qui comporte une grille ou une base pour recevoir une première tension d'entrée (-IN) et un deuxième transistor (T₂) qui comporte une grille ou une base pour recevoir une seconde tension d'entrée (+IN), le premier transistor (T₁) et le deuxième transistor (T₂) formant une paire différentielle de transistors d'attaque ;
en ce que le deuxième étage d'amplification (12) comprend un troisième transistor (T₅) connecté en série à une première source de courant constant (I₂) et situé entre une première source de courant (V_{DD}) et une seconde source de courant (V_{SS}), le troisième transistor (T₅) comportant une grille ou une base connectée à un noeud de sortie (N₃) du premier étage d'amplification (10) et sortant un niveau de tension fonction d'un niveau de tension au noeud de sortie (N₃) ;
en ce que le troisième étage d'amplification (14) comprend un quatrième transistor (T₈) connecté en série à une deuxième source de courant constant (I₅) et situé entre la première source de courant (V_{DD}) et la seconde source de courant (V_{SS}), le quatrième transistor (T₈) comportant une grille ou une base connectée au noeud de sortie (N₃) et sortant un courant de sortie qui est une proportion fixe du courant de sortie du troisième transistor (T₅) ;
caractérisé, en outre, en ce que le circuit de contre-réaction (16) comprend un cinquième transistor (T₉) connecté entre le noeud de sortie (N₃) et la seconde source de courant (V_{SS}), le cinquième transistor (T₉) comportant une grille ou une base connectée à un premier noeud (N₄) connecté au quatrième transistor (T₈) et à la deuxième source de courant constant (I₅), et étant rendu conducteur par une chute de potentiel au premier noeud (N₄), provoquée par une montée de potentiel au noeud de sortie (N₃), et servant à maîtriser la montée de potentiel au noeud de sortie (N₃).

2. Circuit amplificateur selon la revendication 1, comprenant en outre :
un sixième transistor (T₁₈) connecté en série à une troisième source de courant constant (I₁₅) et situé entre la première source de courant (V_{DD}) et la seconde source de courant (V_{SS}), dans lequel :
une grille ou une base du sixième transistor (T₁₈) est connectée au noeud de sortie (N₃) ;
le rapport du courant de sortie du sixième transistor (T₁₈) à celui du troisième transistor (T₅) est fixe ;
le premier étage d'amplification (10) comprend, en outre, un septième transistor (T₃), un huitième transistor (T₄) et une quatrième source de courant constant (I₁) ;
le septième transistor (T₃) et le huitième transistor (T₄) forment un circuit miroir de courant ;
le premier transistor (T₁) et le septième transistor (T₃) sont connectés en série à une quatrième source de courant constant (I₁ ) et sont situés entre la première source de courant (V_{DD}) et la seconde source de courant (V_{SS}) ;
le deuxième transistor (T₂) et le huitième transistor (T₄) sont connectés en série à la quatrième source de courant constant (I₁) et sont situés entre la première source de courant (V_{DD}) et la seconde source de courant (V_{SS}) ;
le circuit de contre-réaction (16) comprend, en outre, un neuvième transistor (T₁₀) connecté entre la quatrième source de courant constant (I₁) et un point de connexion de la grille ou de la base du septième transistor (T₃) et de la grille ou de la base du huitième transistor (T₄) ;
une grille ou une base du neuvième transistor (T₁₀) est connectée à un deuxième noeud (N₁₄) connecté au sixième transistor (T₁₈) et à la quatrième source de courant constant (I₁) ; et
le neuvième transistor (T₁₀) est conducteur en fonction d'une montée de potentiel au deuxième noeud (N₁₄) pour, lorsque le courant de sortie du troisième transistor (T₅) devient égal ou supérieur à une valeur prédéterminée, augmenter le potentiel au noeud de sortie (N₃).

3. Circuit amplificateur comprenant des premier (10), deuxième (12) et troisième étages d'amplification (14) et un circuit de contre-réaction (15) ;
caractérisé :
en ce que le premier étage d'amplification (10) comprend un premier transistor (T₁) qui comporte une grille ou une base pour recevoir une première tension d'entrée (-IN), un deuxième transistor (T₂) qui comporte une grille ou une base pour recevoir une seconde tension d'entrée (+IN), le premier transistor (T₁) et le deuxième transistor (T₂) formant une première paire différentielle de transistors d'attaque ;
en ce que le deuxième étage d'amplification (12) comprend un troisième transistor (T₅) connecté en série à une première source de courant constant (I₂), et situé entre la première source de courant (V_{DD}) et la seconde source de courant (V_{SS}), le troisième transistor (T₅) comportant une grille ou une base connectée à un noeud de sortie (N₃) du premier étage d'amplification connecté au deuxième transistor (T₂) et à un huitième transistor (T₄) et sort un niveau de tension fonction d'un niveau de tension au noeud de sortie (N₃) ;
en ce que le troisième étage d'amplification (14) comprend un quatrième transistor (T₈) connecté en série à une deuxième source de courant constant (I₅), et situé entre la première source de courant (V_{DD}) et la seconde source de courant (V_{SS}), le quatrième transistor (T₈) comportant une grille ou une base connectée au noeud de sortie (N₃) et sortant un courant qui est une proportion fixe du courant de sortie du troisième transistor (T₅) ;
caractérisé, en outre, en ce que le premier étage d'amplification (10) comprend de plus un septième transistor (T₃) et un huitième transistor (T₄), le septième transistor (T₃) et le huitième transistor (T₄) formant un circuit miroir de courant, le premier transistor (T₁) et le septième transistor (T₃) étant connectés en série à une quatrième source de courant constant (I₁) et étant situés entre une première source de courant (V_{DD}) et une seconde source de courant (V_{SS}), et le deuxième transistor (T₂) et le huitième transistor (T₄) étant connectés en série à la quatrième source de courant constant (I₁) et étant situés entre la première source de courant (V_{DD}) et la seconde source de courant (V_{SS}) ; et
en ce que le circuit de contre-réaction (16) comprend un neuvième transistor (T₁₀) connecté entre la quatrième source de courant constant (I₁) et le point de connexion d'une grille ou d'une base du septième transistor (T₃) et d'une grille ou d'une base du huitième transistor (T₄), le neuvième transistor (T₁₀) comportant une grille ou une base connectée à un premier noeud (N₄) connecté au quatrième transistor (T₈) et à la deuxième source de courant constant (I₅) et étant rendu conducteur en fonction d'une montée de potentiel au premier noeud (N₄) pour, lorsqu'un courant de sortie du troisième transistor (T₅) devient égal ou supérieur à une valeur prédéterminée, élever le potentiel au noeud de sortie (N₃).

4. Circuit amplificateur, selon les revendications 1, 2 ou 3, dans lequel ledit premier étage d'amplification, ledit troisième étage d'amplification et ledit circuit de contre-réaction forment une boucle de contre-réaction négative.

5. Circuit amplificateur, selon l'une des revendications 1 ou 2, dans lequel ladite boucle de contre-réaction négative est agencée pour limiter le courant maximal s'écoulant dans le troisième transistor (T₅) inclus dans ledit deuxième étage d'amplification (12), en empêchant ainsi ledit troisième transistor de se bloquer.

6. Circuit amplificateur, selon l'une des revendications 1, 2 ou 5, dans lequel ladite boucle de contre-réaction négative est agencée pour limiter le courant maximal s'écoulant dans le troisième transistor (T₅) inclus dans ledit deuxième étage d'amplification (12), en empêchant ainsi un courant de sortie excessif.

7. Circuit amplificateur, selon l'une quelconque des revendications 1 à 6, dans lequel les transistors inclus dans lesdits premier, deuxième et troisième étages d'amplification et ledit circuit de contre-réaction négative sont des transistors MOS (à semi-conducteurs isolés par oxyde métallique).

8. Circuit amplificateur, selon l'une quelconque des revendications 1 à 6, dans lequel les transistors inclus dans lesdits premier, deuxième et troisième étages d'amplification et ledit circuit de contre-réaction négative sont des transistors bipolaires.
